# FASCICULE DE BREVET EUROPEEN

(11) **EP 1 290 734 B1**
(45) Date de publication et mention de la délivrance du brevet: **01.10.2008**
(21) Numéro de dépôt: 01931829.4
(22) Date de dépôt: 09.05.2001
(51) Int. Cl.: H01L 29/739

(54) **CAPTEUR DE TENSION D'ANODE D'UN COMPOSANT DE PUISSANCE VERTICAL ET UTILISATION EN PROTECTION DE COURT-CIRCUITS**
ANODENSPANNUNGSSENSOR EINES VERTIKALEN LEISTUNGSBAUELEMENTES UND VERWENDUNG ZUM SCHUTZ VON KURZSCHLÜSSEN
ANODE VOLTAGE SENSOR OF A VERTICAL POWER COMPONENT AND USE FOR PROTECTING AGAINST SHORT CIRCUITS

(30) Priorité: 11.05.2000 FR 0006026
(43) Date de publication de la demande: 12.03.2003
(73) Titulaire: CENTRE NATIONAL DE LA RECHERCHE SCIENTIFIQUE (CNRS), 75794 Paris Cedex 16 (FR)
(72) Inventeur: AUSTIN, Patrick, F-31590 Bonrepos-Riquet (FR); LAUR, Jean-Pierre, F-81000 Albi (FR); CAUSSE, Olivier, F-12850 Onet le Château (FR); BREIL, Marie, F-31400 Toulouse (FR); SANCHEZ, Jean-Louis, F-31750 Escalquens (FR); JALADE, Jean, F-31320 Castanet-Tolosan (FR)
(74) Mandataire: Bredema
(86) Numéro de dépôt international: PCT/FR2001/001402
(87) Numéro de publication internationale: WO 2001/086728

(56) Documents cités:
- EP-A- 0 029 932
- EP-A- 0 872 894
- FR-A- 2 532 503
- FR-A- 2 766 993
- US-A- 5 075 751
- IONESCU A M ET AL: "BIPOLAR STATIC INDUCTION TRANSISTOR (BSIT) STATIC MODEL" PROCEEDINGS OF THE MEDITERANNEAN ELECTROTECHNICAL CONFERENCE,US,NEW YORK, IEEE, vol. CONF. 6, 22 mai 1991 (1991-05-22), pages 107-110, XP000255352
- P.B. ANJANEYULU ET AL.: INT. J. ELECTRONICS, vol. 50, no. 6, 1981, pages 477-484, XP000946269
- R. AROCKIASAMY: ELECTRONIC ENGINEERING, vol. 46, no. 556, juin 1974 (1974-06), pages 14-17, XP000951463
- BALIGA B J: "TRENDS IN POWER SEMICONDUCTOR DEVICES" IEEE TRANSACTIONS ON ELECTRON DEVICES, IEEE INC. NEW YORK, US, vol. 43, no. 10, 1 octobre 1996 (1996-10-01), pages 1717-1731, XP000626907 ISSN: 0018-9383 cité dans la demande

## Description

La présente invention concerne de façon générale les composants de puissance verticaux. Elle concerne plus particulièrement la fourniture d'une tension liée à la tension d'anode d'un tel composant.

De façon générale, dans les composants de puissance verticaux, la face arrière est uniformément métallisée et correspond à l'anode du composant, tandis que la face avant comprend une métallisation de cathode et une ou plusieurs bornes de commande. Généralement, l'anode est portée à un potentiel élevé et il peut être utile de pouvoir disposer d'une tension de détection variant dans le même sens que la tension d'anode.

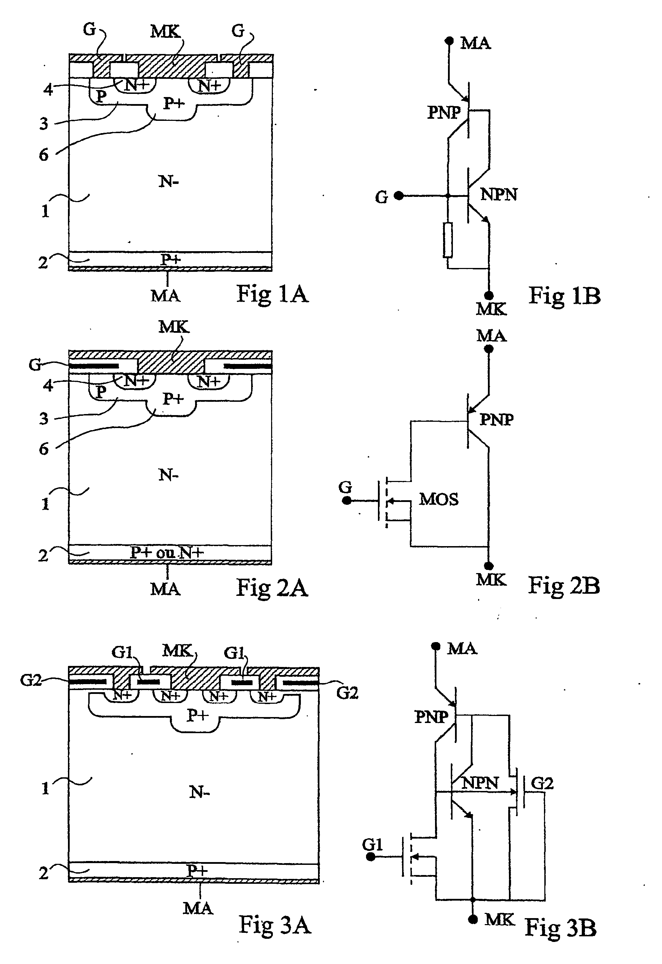

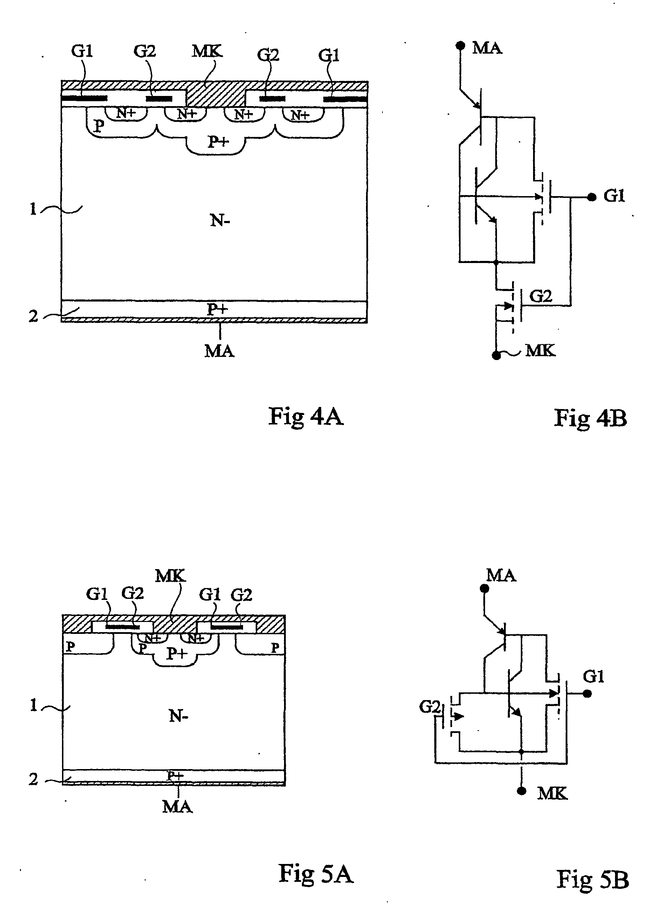

Les figures 1A à 5A représentent des vues en coupe simplifiées de divers exemples de composants de puissance verticaux de type cellulaire. Les figures 1B à 5B représentent des schémas équivalents. Dans tous les cas, on considère que la structure est formée à partir d'un substrat 1 faiblement dopé de type N.

La figure 1A représente une vue en coupe d'une cellule d'un thyristor de type cellulaire. Du côté de la face arrière du substrat 1 est formée une couche 2 de type P correspondant à la couche d'anode et revêtue d'une métallisation d'anode MA. Du côté de la face avant est formé un caisson 3 de type P dans lequel sont formées des régions de cathode 4 fortement dopées de type N. De préférence, la partie centrale de chaque caisson comporte une région 6 fortement dopée de type P. Une métallisation de cathode MK est solidaire des régions 4 et 6 et une métallisation de gâchette G est solidaire du caisson 3.

La figure 1B représente le schéma équivalent classique d'un thyristor constitué de l'association de deux transistors PNP et NPN. En figure 1B comme dans les figures 2B à 5B, l'anode est représentée en haut de la figure, alors que dans les vues en coupe des figures 1A à 5A, l'anode est représentée en bas de la figure.

La figure 2A représente une vue en coupe d'un transistor MOS vertical ou d'un transistor IGBT. Dans le cas d'un transistor de type MOS, la couche 2 de face arrière est de type N⁺. Dans le cas d'un transistor IGBT, la couche 2 de face arrière est de type P⁺. La structure diffusée du côté de la face avant est similaire à celle d'un thyristor cellulaire et comprend un caisson 3 de type P, une région 4 de type N⁺ et une région 6 de type P⁺. La métallisation de cathode MK est similaire à celle de la figure 1A. L'électrode de commande correspond à une métallisation de grille G isolée de la périphérie du caisson 3 et formée au-dessus de celle-ci. La figure 2B représente le schéma équivalent dans le cas où la couche 2 est de type P⁺, c'est-à-dire que le composant est un transistor IGBT. Cette structure comprend l'association d'un transistor PNP et d'un transistor MOS à enrichissement connecté entre base et collecteur du transistor PNP.

Les figures 3A et 3B représentent un thyristor MOS auto-amorçable et blocable.

Les figures 4A et 4B représentent une structure de thyristor à commutation par l'émetteur, couramment appelée structure EST, ces lettres correspondant aux initiales des termes anglo-saxons Emitter Switched Thyristor.

Les figures 5A et 5B représentent une vue en coupe d'une structure de thyristor à résistance de base, couramment désignée par le sigle BRT, ces lettres correspondant aux initiales des termes anglo-saxons Base Resistor Thyristor.

Les figures 3 à 5 ne seront pas décrites plus en détail, on notera simplement que du côté de la face arrière est prévue une couche 2 de type P⁺ revêtue d'une métallisation d'anode MA. Pour simplifier la compréhension de ces structures, on a désigné par G1 et G2 les grilles des transistors MOS impliqués en figures 3A, 4A et 5A et on a désigné de la même façon ces grilles dans les schémas équivalents des figures correspondantes 3B, 4B et 5B. Pour plus de détails, on pourra se référer à "Trends in Power Semiconductor Devices", B. J. Baliga, IEEE Transactions on Electron Devices, vol. 43, octobre 1996, PP. 1717-1731 (correspondant à la préambule de la revendication 1).

Les figures 1 à 5 ont été décrites uniquement pour rappeler la structure de quelques exemples de composants verticaux auxquels est susceptible de s'appliquer la présente invention.

L'objet de la présente invention est de prévoir un capteur de tension susceptible de fournir, sur une électrode de face avant du composant une tension nettement inférieure à la tension d'anode mais variant dans le même sens que cette tension d'anode. En d'autre termes, on cherche à obtenir une tension qui soit l'image de la tension d'anode.

Pour atteindre cet objet, la présente invention prévoit un dispositif comprenant un composant de puissance vertical choisi dans le groupe comprenant les composants dits thyristor, transistor MOS, IGBT, PMCT, EST, BRT, thyristor MOS, thyristor MOS blocable, formés dans un substrat de type N faiblement dopé et dont la face arrière revêtue d'une métallisation correspond à l'anode du composant, comprenant un capteur de tension d'anode comprenant, du côté de la face avant, une zone du substrat entourée au moins partiellement d'une région de type P à un potentiel bas devant un potentiel d'anode, ladite zone étant revêtue d'une métallisation en contact ohmique avec elle, sur laquelle est fournie une image de la tension d'anode.

Selon un mode de réalisation de la présente invention, la métallisation est formée sur une région fortement dopée de type N.

Selon un mode de réalisation de la présente invention, la métallisation d'anode est formée sur une région de type P⁺.

En outre, la présente invention vise une utilisation particulière d'un tel capteur pour détecter si la charge connectée au composant de puissance est en court-circuit.

La présente invention prévoit aussi une utilisation du capteur de tension d'anode susmentionné, pour inhiber le fonctionnement d'un composant de puissance vertical quand la tension détectée dépasse un seuil prédéterminé.

La présente invention prévoit aussi un circuit de commande de blocage d'un composant de puissance vertical comprenant un capteur de tension tel que susmentionné, dont la tension de sortie est appliquée à la borne de commande d'un interrupteur connecté entre la cathode et la borne de commande d'un composant de puissance vertical ouvrable quand cette borne de commande est reliée à la cathode, un circuit de retard étant interposé entre la tension de capteur et la borne de gâchette.

Selon un mode de réalisation de la présente invention, le circuit de retard comprend un transistor MOS, dont la gâchette reçoit le signal du capteur et dont le circuit principal est connecté entre la gâchette dudit interrupteur et une résistance connectée à la borne de commande du composant vertical.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 5A représentent des vues en coupe partielles des composants de puissance verticaux ;
les figures 1B à 5B représentent des schémas équivalents des structures des figures 1A à 5A ;

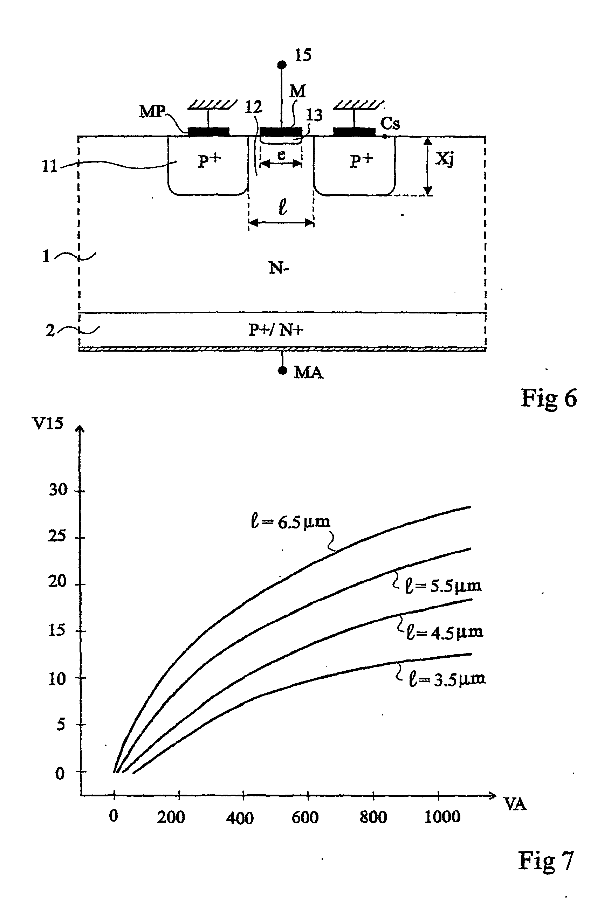

la figure 6 représente une vue en coupe simplifiée d'un capteur de tension d'anode selon la présente invention ;
la figure 7 représente la tension aux bornes du capteur en fonction de la tension d'anode dans diverses conditions ;

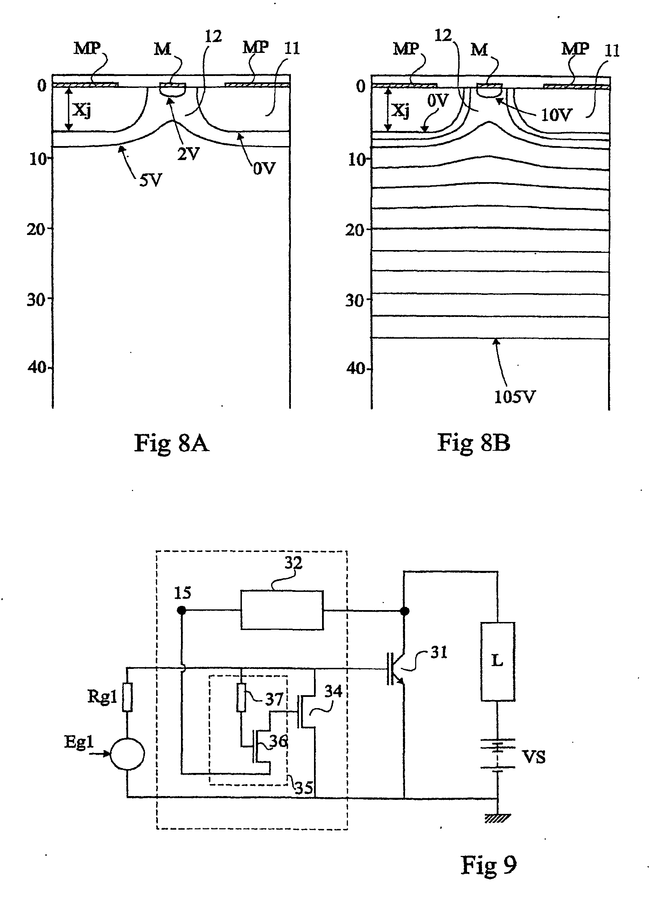

les figures 8A et 8B représentent des exemples de répartition d'équipotentielles du capteur selon la présente invention dans diverses configurations ;
la figure 9 représente un exemple d'application de la présente invention à la protection contre un court-circuit de la charge dans le cas d'un transistor IGBT ;

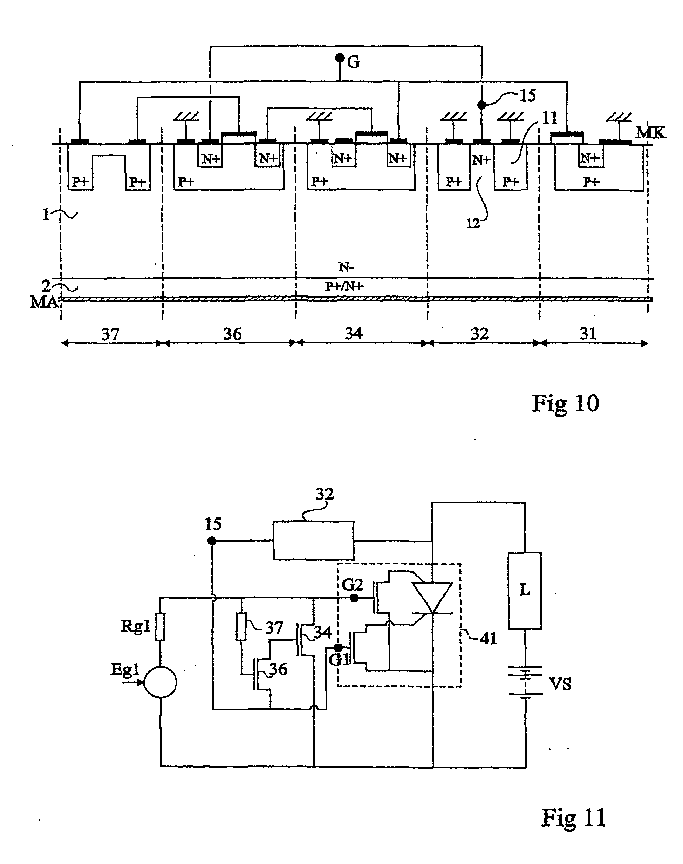

la figure 10 représente de façon très simplifiée une structure intégrée correspondant au schéma de la figure 9 ; et
la figure 11 représente un schéma de structure de protection contre les courts-circuits dans le cas où le composant de puissance verticale est un thyristor MOS blocable.

De façon générale, les structures de composants verticaux dont des exemples ont été donnés précédemment comprennent un substrat 1 de type N faiblement dopé, dont la face arrière est revêtue d'une métallisation d'anode MA, avec interposition d'une couche 2 fortement dopée, de type N (par exemple dans le cas d'un transistor MOS vertical) ou de type P (dans le cas des autres exemples donnés précédemment).

Une vue en coupe simplifiée d'un capteur selon la présente invention est illustrée en figure 6. Ce capteur est formé du côté de la face avant du composant, dans le substrat 1. Il comprend une région 11 fortement dopée de type P délimitant une zone 12 du substrat. La région 11 peut être une région annulaire enfermant complètement la région 12 ou correspondre à deux bandes délimitant une bande intermédiaire correspondant à la zone 12. Une région 13 fortement dopée de type N est formée à la partie supérieure de la zone 12 et est revêtue d'une métallisation M reliée à une borne 15 sur laquelle est disponible la tension de détection souhaitée (V₁₅). La surface supérieure de la ou des régions 11 de type P⁺ est revêtue d'une métallisation MP qui est connectée à un potentiel de référence faible devant le potentiel de l'anode, par exemple le potentiel de référence de l'alimentation auquel est destiné à être connecté le composant, couramment la masse, ce potentiel étant par exemple aussi le potentiel de cathode.

En figure 6, on a désigné par Cs la concentration en surface des régions 11 de type P⁺, par Xj la profondeur de jonction des régions 11, par ℓ la largeur de la région 12, par exemple la distance entre deux bandes 11 ou le diamètre interne d'un anneau correspondant à une région 11 unique, et par e la longueur de la métallisation M.

On constate que, quand une tension est appliquée à l'anode MA, la tension sur la borne 15 varie dans le même sens que cette tension d'anode. La valeur de la tension sur la borne 15 et son mode de variation dépendent des divers paramètres Cs, Xj, ℓ et e susmentionnés, ainsi que de l'épaisseur W de la plaquette.

A titre d'exemple, la figure 7 indique la variation de la tension V₁₅ sur la borne 15 du capteur en fonction de la tension VA sur l'anode du composant dans le cas où W = 300 µm, Xj = 6 µm, Cs = 2.10¹⁹ at./cm³ et e = 4 µm, pour des valeurs de ℓ respectivement égales à 3,5, 4,5, 5,5 et 6,5 µm. On considère le cas où la tension d'anode varie entre 0 et 1000 volts. On voit que la tension de capteur augmente avec la tension d'anode et, pour une tension d'anode donné, avec la valeur de ℓ. Bien que la tension du capteur ne soit pas proportionnelle à la tension d'anode, elle varie dans le même sens et de façon régulière. La tension du capteur est donc une bonne image de la tension d'anode. Elle pourra selon les réglages choisis varier entre 0 et 10 volts et entre 0 et 30 volts ou plus. Quand les paramètres Xj et Cs augmentent, c'est-à-dire quand l'importance de la région diffusée 11 délimitant la zone 12 où est située l'électrode de capteur augmente, la tension du capteur, pour une valeur donnée de la tension d'anode et des autres paramètres, diminue.

L'homme de l'art comprendra que ces courbes s'expliquent par la répartition des équipotentielles quand le composant est sous tension. Les figures 8A et 8B représentent le résultat de stimulations sur l'allure de ces équipotentielles qui montrent bien que l'on atteint le résultat recherché. Dans le cas de la figure 8A, l'anode est à un potentiel de 5 V et dans le cas de la figure 8B l'anode est à un potentiel de 105 V. Dans le premier cas, on trouve au niveau de la région diffusée 13 de la zone de test une tension de l'ordre de 2 V et dans le deuxième cas une tension de l'ordre de 10 V. On notera que l'équipotentielle 0 V correspond sensiblement à la profondeur de diffusion Xj des régions 11.

Ainsi, la présente invention permet de disposer du côté de la face avant d'un composant vertical de puissance d'une tension image de la tension anode/cathode de ce composant. Cette tension image pourra être utilisée par l'homme de l'art à diverses applications de commande ou de protection. On donnera ci-après un exemple d'application dans lequel la tension d'anode est utilisée comme moyen de détection d'un court-circuit dans la charge, pour commander à l'ouverture le composant de puissance vertical.

La figure 9 illustre une telle application de la présente invention dans laquelle le composant vertical de puissance est un transistor IGBT 31 connecté en série avec une charge L et une tension d'alimentation VS. Le capteur intégré selon la présente invention est schématisé sous forme d'un bloc 32 interposé entre l'anode du transistor IGBT 31 et la borne 15 de fourniture de la tension image. Le transistor 31 est classiquement associé à un circuit de mise en conduction comprenant une résistance Rg1 en série avec une source de tension commandable Eg1 susceptible de fournir un créneau de tension positif quand on veut que le transistor IGBT conduise. Entre la grille et la cathode du transistor IGBT 31 est inséré un transistor MOS d'ouverture 34 qui est relié à la borne de détection 15 par l'intermédiaire d'un circuit de retard 35. Le circuit de retard 35 comprend par exemple un transistor MOS 36 en série entre la grille du transistor 34 et la borne 15. La grille du transistor 36 est connectée à la borne de commande du transistor 31 par l'intermédiaire d'une résistance 37. Le fonctionnement du circuit de la figure 9 est le suivant. Pendant les phases de conduction du transistor 31, si la charge L vient en court-circuit, le transistor 31 voit sensiblement toute la tension d'alimentation VS, c'est-à-dire que sa tension d'anode monte par rapport à sa tension de cathode. Cette augmentation se traduit par une augmentation de la tension image sur la borne 15. Le seuil de mise en conduction du transistor 34 est choisi pour que, dès que la tension sur la borne 15 dépasse une valeur déterminée, le transistor 34 entre en conduction. Le circuit de retard 35 empêche le transistor 34 de devenir conducteur dès le début d'une phase de mise en conduction normale. En effet, quand le transistor 31 est initialement bloqué, la tension sur la borne 15 est élevée puis chute ensuite rapidement au début de la phase de mise en conduction si la charge est normale. En l'absence du circuit de retard 35, le transistor 34 deviendrait donc conducteur au début de chaque mise en conduction. La constante de temps lié à la présence de la résistance 37 et de la capacité de grille du transistor 36 entraîne que le signal sur la borne 15 n'est pris en compte qu'après un certain retard après l'application d'un signal de mise en conduction. A ce moment, la borne 15 est à un niveau souhaité (bas si la charge est normale, haut si la charge est court-circuitée).

Par contre si la charge entre en court-circuit pendant une phase de conduction normale, le circuit de retard n'agit plus et le transistor 34 est immédiatement rendu passant, ce qui est souhaité.

On notera que l'essentiel des composants de la figure 9 est intégrable, comme cela est représenté de façon très schématiquement en figure 10 où les emplacements des divers éléments de la figure 9 sont représentés par leurs références.

Dans le schéma de la figure 9, le composant 31 peut être remplacé par d'autres composants verticaux à condition bien entendu que ces composants soient de type ouvrable par la gâchette, ce qui n'est par exemple pas le cas d'un thyristor classique. Pour certains composants, on pourra réaliser une ouverture immédiatement après l'amorçage alors que cet amorçage n'est pas encore complet mais par contre on ne pourra pas réaliser l'ouverture une fois qu'un courant important traverse le composant principal, si la charge se met en court-circuit pendant une phase de conduction.

La figure 11 représente une application particulière de la présente invention à un circuit de type thyristor MOS blocable tel que représenté en figures 3A et 3B. Pour ouvrir ce composant, il faut connecter simultanément à la cathode les bornes de gâchette d'anode G2 et de gâchette de cathode G1. En figure 11, les mêmes éléments qu'en figure 9 sont désignés par de mêmes références. Ainsi, en figure 11, le composant 31 de la figure 9 est remplacé par un composant 41 de type du thyristor MOS blocable. Le dispositif de commande de la grille G2 de ce composant est identique à celui de la figure 9 et comprend des éléments 34, 36 et 37. En outre, la tension image de la tension d'anode est appliquée directement à la grille G1, de façon à court-circuiter la cathode et la gâchette de cathode du thyristor blocable quand la charge est en court-circuit.

Bien entendu, la présente invention est susceptible de diverses variantes et modifications qui apparaîtront à l'homme de l'art. En particulier, alors que l'on a décrit uniquement des composants verticaux de puissance constitués à partir d'un substrat faiblement dopé de type N, on pourrait réaliser des composants similaires de type opposé réalisé à partir d'un substrat de type P. La face arrière étant alors la face de cathode et le système de détection devenant un système de détection de la tension de cathode par rapport à la tension d'anode.

## Revendications

1. Dispositif comprenant un composant de puissance vertical choisi dans le groupe comprenant les composants dits thyristor, transistor MOS, IGBT, PMCT, EST, BRT, thyristor MOS, thyristor MOS blocable, formés dans un substrat de type N
(1) faiblement dopé et dont la face arrière (2) revêtue d'une métallisation (MA) correspond à l'anode du composant, **caractérisé en ce que** le dispositif comprend un capteur de tension d'anode comprenant, du côté de la face avant, une zone (12) du substrat entourée au moins partiellement d'une région (11) de type P à un potentiel bas devant un potentiel d'anode, ladite zone (12) étant revêtue d'une métallisation (M) en contact ohmique avec elle, sur laquelle est fournie une image de la tension d'anode.

2. Dispositif selon la revendication 1, **caractérisé en ce que** la métallisation (M) est formée sur une région (13) fortement dopée de type N.

3. Dispositif de tension d'anode selon la revendication 1, **caractérisé en ce que** la métallisation d'anode est formée sur une région (2) de type P⁺.

4. Utilisation du capteur de tension d'anode selon la revendication 1, pour inhiber le fonctionnement du composant de puissance vertical quand la tension détectée dépasse un seuil prédéterminé.

5. Circuit de commande de blocage d'un dispositif selon la revendication 1, dont la tension de sortie est appliquée à la borne de commande d'un interrupteur (34) connecté entre la cathode et la borne de commande du composant de puissance vertical ouvrable quand cette borne de commande est reliée à la cathode, un circuit de retard (35) étant interposé entre la tension de capteur et la borne de gâchette.

6. Circuit de commande selon la revendication 5, **caractérisé en ce que** le circuit de retard (35) comprend un transistor MOS (36), dont la gâchette reçoit le signal du capteur et dont le circuit principal est connecté entre la gâchette dudit interrupteur et une résistance (37) connectée à la borne de commande du composant vertical.

## Claims

1. A device comprising a vertical power component selected from the group comprising the components called thyristor, MOS, IGBT, PMCT, EST, BRT transistor, MOS thyristor, turn-off MOS thyristor formed in a lightly doped N-type substrate
(1) and the rear face (2) of which being coated with a metallization (MA) corresponds to the component anode, **characterized in that** the device comprises: an anode voltage sensor comprising, on the front face side, an area (12) of the substrate at least partially surrounded by P-type region (11) with low potential in front of an anode potential, said area (12) being coated with a metallization (M) in ohmic contact therewith, on which an image of the anode voltage is provided.

2. A device according to claim 1, **characterized in that** the metallization (M) is formed on a strongly doped N-type region (13).

3. An anode voltage device according to claim 1, **characterized in that** the anode metallization is formed on a P⁺-type region (2).

4. The utilization of the anode voltage sensor according to claim 1, in order to inhibit the operation of the vertical power component when the detected voltage exceeds a predetermined threshold.

5. A control circuit for locking a device according to claim 1, the output voltage of which is applied to the control terminal of a switch (34) connected between the cathode and the control terminal of the turn-on vertical power component when such control terminal is connected to the cathode, a delay circuit (35) being interposed between the sensor voltage and the trigger gate terminal.

6. A control circuit according to claim 5, **characterized in that** the delay circuit (35) comprises a MOS transistor (36), the trigger gate of which receives the signal from the sensor and the main circuit of which is connected between the trigger gate of said switch and a resistance (37) connected to the vertical component control terminal.

## Patentansprüche

1. Vorrichtung, die einen vertikalen Leistungsbauteil umfasst, das aus der Gruppe von Bauteilen, dem sogenanntem Thyristor, Transistor MOS, IGBT, PMCT, EST, BRT, Thyristor MOS, sperrbarer Thyristor MOS gewählt wird, die in einem schwach gedopten Substrat von der Art N (1) gebildet werden, und dessen mit einem Metallüberzug (MA) versehene Rückseite (2) der Anode des Bauteils entspricht, **dadurch gekennzeichnet, daß** die Vorrichtung umfaßt: einen Anodenspannungsaufnehmer, der an der Seite der Vorderseite eine Zone (12) des Substrats umfaßt, die zumindest teilweise von einem Bereich (11) von der Art P mit einem niedrigen Potential vor einem Anodenpotential umgeben ist, wobei die besagte Zone (12) mit einem Metallüberzug (M) versehen ist, der in ohmischem Kontakt mit ihr ist, auf der ein Bild der Anodenspannung gegeben ist.

2. Vorrichtung nach Anspruch 1, **dadurch gekennzeichnet, daß** der Metallüberzug (M) auf einer stark gedopten Region (13) von der Art N gebildet ist.

3. Vorrichtung mit Anodenspannung nach Anspruch 1, **dadurch gekennzeichnet, daß** der Metallüberzug der Anode auf einer Region (2) von der Art P⁺ gebildet wird.

4. Benutzung des Anodenspannungsaufnehmers nach Anspruch 1 zum Hemmen des Betriebs des vertikalen Leistungsbauteils, wenn die entdeckte Spannung eine vorbestimmte Schwelle übersteigt.

5. Steuerkreis der Sperrung einer Vorrichtung nach Anspruch 1, dessen Ausgangsspannung an der Steuerklemme eines Schalters (34) angelegt wird, der zwischen der Kathode und der Steuerklemme des vertikalen Leistungsbauteils angeschlossen ist und geöffnet werden kann, wenn diese Steuerklemme mit der Kathode verbunden ist, wobei zwischen der Aufnehmerspannung und dem Steueranschluß eine Verzögerungsleitung eingeschaltet ist.

6. Steuerkreis nach Anspruch 5, **dadurch gekennzeichnet, daß** die Verzögerungsleitung (35) einen Transistor MOS (36) umfaßt, dessen Steuerung das Signal des Aufnehmers erhält, und dessen Hauptschaltkreis zwischen der Steuerung des besagten Schalters und einem Widerstand (37) angeschlossen ist, der an der Steuerklemme des vertikalen Bauteils angeschlossen ist.
